# EUROPEAN PATENT APPLICATION

(11) **EP 4 632 389 A1**
(43) Date of publication of application: **15.10.2025**
(21) Application number: 25168067.4
(22) Date of filing: 02.04.2025
(51) Int. Cl.: G01P 15/125, G01C 19/5733, G01P 15/18, G01P 15/08

(54) **FULLY SYMMETRICAL ELECTRODE STRUCTURES FOR MICROELECTROMECHANICAL DEVICES**

(30) Priority: 09.04.2024 US 202463631631 P; 28.03.2025 US 202519093955
(71) Applicant: Analog Devices, Inc., Wilmington, MA 01887 (US)
(72) Inventor: ZHANG, Jianglong, Wilmington, MA 01887 (US); VOHRA, Gaurav, Wilmington, MA 01887 (US); JIA, Kemiao, Wilmington, MA 01887 (US)
(74) Representative: Wallin, Nicholas James

(57) **Abstract**

Fully symmetric sensing structures for MEMS devices are disclosed herein. In certain embodiments, a MEMS sensor includes a proof mass that moves in a first direction. The proof mass includes moveable fingers that move with the proof mass. The MEMS sensor further includes fixed fingers that are fixed with respect to the moveable fingers, and the fixed fingers and moveable fingers serve to detect movement of the proof mass. For example, the moveable fingers and the fixed fingers can be interdigitated to form a comb finger set for sensing changes in capacitance arising from movement of the proof mass relative to a substrate. A layout of the fixed fingers is fully symmetric in at least the first direction.

## Description

### Priority Claim

This European patent application claims priority from United States Provisional Patent Application No. 63/631,631 filed 9 April 2024, and from United States Patent Application No. 19/093,955, filed 28 March 2025.

### Field of the Disclosure

Embodiments of the invention relate to electronics, and more particularly to microelectromechanical systems (MEMS).

### BACKGROUND

A MEMS sensor, such as a MEMS accelerometer or a MEMS gyroscope, includes a proof mass that moves in response to inertial forces. Additionally, the MEMS sensor includes a sensing structure, such as a capacitive sensing structure having moveable fingers attached to the proof mass and fixed fingers anchored to a substrate. The moveable fingers and the fixed fingers can be interdigitated to form comb finger sets that serve to sense capacitance changes arising from the proof mass moving relative to the substrate.

In an accelerometer, a proof mass can be suspended by spring tethers over a substrate and provide a resistance against acceleration forces. Additionally, the sensing structure measures a deflection of the proof mass resulting in a sensor output with amplitude proportional to acceleration. In another example, a gyroscope can include a proof mass that moves in a first direction (for example an X-direction) while the sensing structure detects a Coriolis effect in a second direction (for example, a Y-direction) arising from movement of the proof mass.

### SUMMARY OF THE DISCLOSURE

In one aspect, a MEMS sensor is disclosed. The MEMS sensor includes a proof mass configured to move in a first direction, and the proof mass includes a plurality of moveable fingers that move with the proof mass. The MEMS sensor further includes a plurality of fixed fingers that are fixed with respect to the plurality of moveable fingers. A layout of the plurality of fixed fingers is fully symmetric in at least the first direction.

In another aspect, a method of MEMS sensing is disclosed. The method includes moving a proof mass in a first direction, the proof mass including a plurality of moveable fingers that move with the proof mass. The method further includes sensing a movement of the proof mass using the plurality of moveable fingers and a plurality of fixed fingers that are fixed with respect to the plurality of moveable fingers. A layout of the plurality of fixed fingers is fully symmetric in at least the first direction.

### BRIEF DESCRIPTION OF THE DRAWINGS

Figure 1A is a plan view of one example of a MEMS accelerometer.
Figure 1B is a plan view of a capacitive sensing structure of the MEMS accelerometer of Figure 1A.
Figure 2A is a plan view of a MEMS accelerometer with fully symmetrical sensing structures according to one embodiment.
Figure 2B is a plan view of a capacitive sensing structure of the MEMS accelerometer of Figure 2A.
Figure 3A is a plan view of a capacitive sensing structure according to another embodiment.
Figure 3B is a first cross-section of the capacitive sensing structure of Figure 3A.
Figure 3C is a second cross-section of the capacitive sensing structure of Figure 3A.
Figure 4A is a plan view of a capacitive sensing structure according to another embodiment.
Figure 4B is a first cross-section of the capacitive sensing structure of Figure 4A.
Figure 4C is a second cross-section of the capacitive sensing structure of Figure 4A.
Figure 5A is a plan view of a capacitive sensing structure according to another embodiment.
Figure 5B is a first cross-section of the capacitive sensing structure of Figure 5A.
Figure 5C is a second cross-section of the capacitive sensing structure of Figure 5A.
Figure 5D is a third cross-section of the capacitive sensing structure of Figure 5A.
Figure 6 is a plan view of a capacitive sensing structure according to another embodiment.
Figure 7A is a plan view of a capacitive sensing structure according to another embodiment.
Figure 7B is a first cross-section of the capacitive sensing structure of Figure 7A.
Figure 7C is a second cross-section of the capacitive sensing structure of Figure 7A.
Figure 7D is a third cross-section of the capacitive sensing structure of Figure 7A.
Figure 8A is a plan view of one example of a MEMS gyroscope.
Figure 8B is a plan view of a capacitive sensing structure of the MEMS gyroscope of Figure 8A.
Figure 9A is a plan view of a MEMS gyroscope with fully symmetrical sensing structures according to one embodiment.
Figure 9B is a plan view of a capacitive sensing structure of the MEMS gyroscope of Figure 9A.

### DETAILED DESCRIPTION OF EMBODIMENTS

The following detailed description of embodiments presents various descriptions of specific embodiments of the invention. However, the invention can be embodied in a multitude of different ways. In this description, reference is made to the drawings where like reference numerals may indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

Certain MEMS sensors are designed with movable fingers that may have some symmetry. However, such designs are not fully symmetrical due to layout limitations. For example, a MEMS sensor could have fixed fingers extending only on one side of a fixed anchor, and when the anchor rotates due to stress, the sensing gap changes and leads to a change in sensor offset and/or quadrature errors.

Fully symmetric sensing structures for MEMS devices are disclosed herein. In certain embodiments, a MEMS sensor includes a proof mass that moves in a first direction. The proof mass includes moveable fingers that move with the proof mass. The MEMS sensor further includes fixed fingers that are fixed with respect to the moveable fingers, and the fixed fingers and moveable fingers serve to detect movement of the proof mass. For example, the moveable fingers and the fixed fingers can be interdigitated to form a comb finger set for sensing changes in capacitance arising from movement of the proof mass relative to a substrate. A layout of the fixed fingers is fully symmetric in at least the first direction.

Implementing MEMS sensors with fully symmetrical sensing structures achieves significant offset performance under package and/or internal/external stress. For example, an unsymmetrical design of a comb finger set causes offset shift due to the different movement of the fixed fingers under stress.

Accordingly, fully symmetrical sensing structures are provided herein for MEMS sensors, such as MEMS accelerometers or MEMS gyroscopes. The structures are fully symmetric in at least one direction by design (fully symmetric absent manufacturing variation or imperfections). In certain implementations, the structures are fully symmetric in at least two directions. MEMS sensors are also referred to herein as MEMS devices.

Thus, each fixed finger can be fully symmetric with respect to its anchor and/or each fixed finger set can be fully symmetric with respect to a movable finger. Accordingly, effects of fixed finger anchor rotation can be cancelled.

The MEMS sensors can also be implemented with coalignment of the fixed finger anchors, which reduces offset generated by a location difference of the fixed anchors.

Such coalignment of the anchors of the fixed fingers can be implemented in a wide variety of ways. For example, the fixed fingers can be anchored to a substate only at the center of each finger, at the ends of each finger, fully anchored by the whole finger, and/or any other desired configuration of anchoring with coalignment.

In certain implementations, the anchors for the fixed fingers are electrically conductive and serve to provide electrical connections to polysilicon or metal conductors. Thus, electrically conductive anchors allow for the voltage potential of the conductors to be controlled and/or sensed. The anchors can also include one or more anchors formed from oxide, such as by an additional oxide/dielectric layer under the finger. Such oxide finger anchors are non-conductive but provide a structural anchoring function for the fixed fingers.

In one example, oxide finger anchors are formed of a sacrificial oxide that is also used beneath the proof mass. The sacrificial oxide is removed beneath the proof mass to form a cavity and left beneath the fingers to form oxide finger anchors. In another example, an oxide is pre-etched and the fingers are bonded on top of the pre-etched oxide. Any suitable oxide or other dielectric layer can be used to form non-conductive finger anchors.

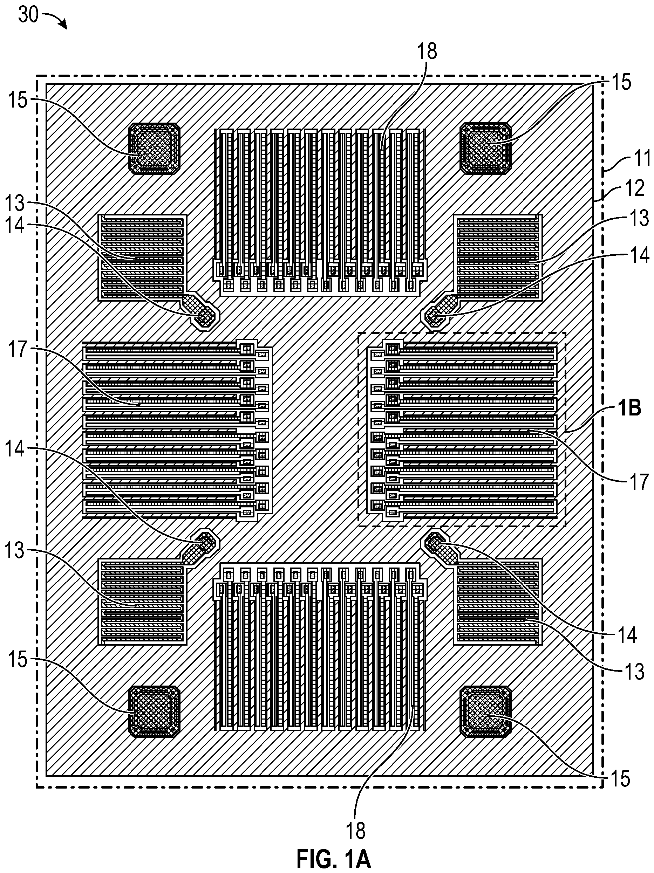

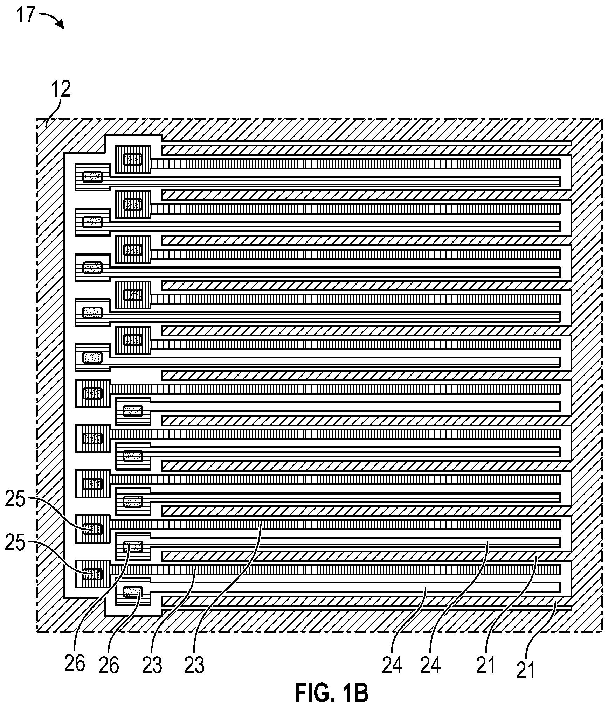

Figure 1A is a plan view of one example of a MEMS accelerometer 30. The MEMS accelerometer 30 includes a substrate 11, a proof mass 12, springs 13, spring anchors 14, stoppers 15, first direction capacitive sensing structures 17, and second direction capacitive sensing structures 18. Figure 1B is a plan view of one of the first direction capacitive sensing structures 17 of the MEMS accelerometer 30 of Figure 1A.

With reference to Figures 1A to 1B, the MEMS accelerometer 30 includes the proof mass 12 that is suspended by the springs 13 over the substrate 11. The MEMS accelerometer 30 also includes the capacitive sensing structures 17/18 for measuring a deflection of the proof mass 12 in first and second directions.

As shown in Figure 1B, capacitive sensing structure 17 includes moveable fingers 21 that move with the proof mass 12. The capacitive sensing structure 17 also includes a first set of fixed fingers 23 that are anchored to the substrate 11 by a first set of finger anchors 25, and a second set of fixed fingers 24 that are anchored to the substrate 11 by a second set of finger anchors 26. The movable fingers 21 and fixed fingers 23/24 are interdigitated to form comb finger sets for sensing capacitance. As the sensed capacitance changes, the comb finger sets detect a deflection of the proof mass 12.

With continuing reference to Figures 1A and 1B, the layout of each capacitive sensing structure has several asymmetries.

For example, as shown in Figure 1B the moveable fingers 21 of the capacitive sensing structure 17 extend from only one side of the proof mass 12. Furthermore, the first set of finger anchors 25 and the second set of finger anchors 26 are positioned on one end of each finger. Moreover, the first set of finger anchors 25 are not aligned with the second set of finger anchors 26.

Such asymmetries give rises to changes in sensor offset. For example, when the finger anchors rotate due to stress, the sensing gap between the moveable fingers 21 and the fixed fingers 23/24 changes and causes a change in sensor offset.

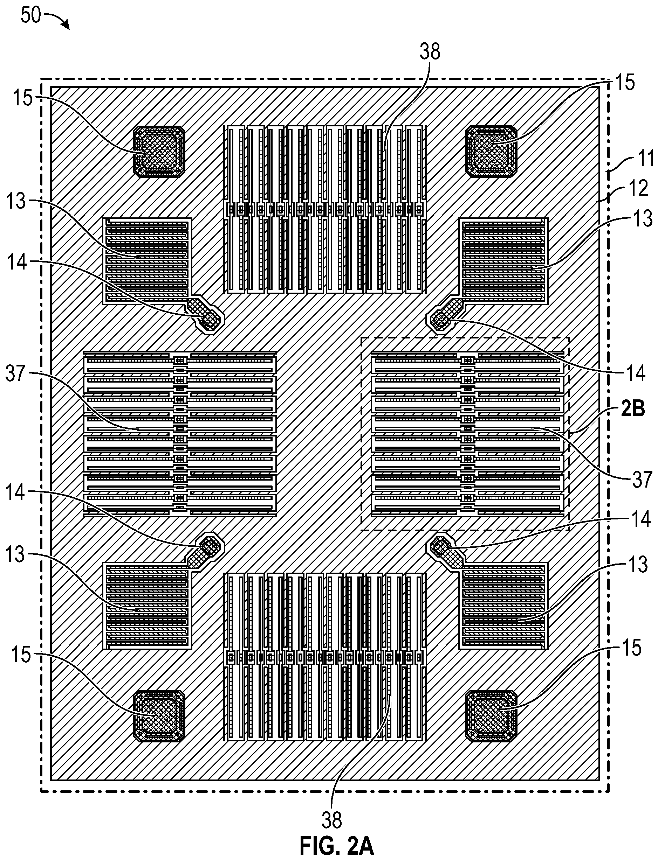

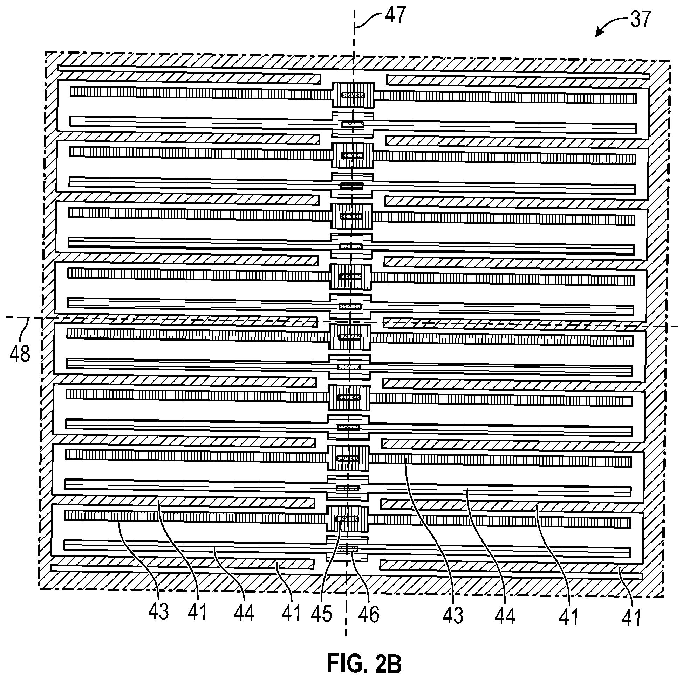

Figure 2A is a plan view of a MEMS accelerometer 50 with fully symmetrical sensing structures according to one embodiment. The MEMS accelerometer 50 includes a substrate 11, a proof mass 12, springs 13, spring anchors 14, stoppers 15, first direction capacitive sensing structures 37, and second direction capacitive sensing structures 38. Figure 2B is a plan view of one of the first direction capacitive sensing structures 37 of the MEMS accelerometer 50 of Figure 2A.

With reference to Figures 2A to 2B, the MEMS accelerometer 50 includes the proof mass 12 that is suspended by the springs 13 over the substrate 11. The MEMS accelerometer 50 also includes the capacitive sensing structures 37/38 for measuring a deflection of the proof mass 12.

As shown in Figure 2B, capacitive sensing structure 37 includes moveable fingers 41 that move with the proof mass 12. The capacitive sensing structure 37 also includes a first set of fixed fingers 43 that are anchored to the substrate 11 by a first set of finger anchors 45, and a second set of fixed fingers 44 that are anchored to the substrate 11 by a second set of finger anchors 46. The movable fingers 41 and fixed fingers 43/44 are interdigitated to form comb finger sets for sensing capacitance.

With continuing reference to Figures 2A and 2B, the layout of each capacitive sensing structure is fully symmetric.

For example, as shown in Figure 2B the moveable fingers 41 of the capacitive sensing structure 37 extend symmetrically from opposite sides of the proof mass 12 rather than from just one side.

Additionally, the fixed fingers 43/44 shown in Figure 2B are symmetrically anchored. In contrast, the fixed fingers 23/24 shown in Figure 1B are anchored on only one end of each finger.

Moreover, the first set of finger anchors 45 are aligned along the y-axis 47 with the second set of finger anchors 46. Such anchor co-alignment reduces sensor offset generated by a location/stress difference of the fixed anchors.

Thus, the moveable fingers 41 are fully symmetric with respect to the y-axis 47 as well as the x-axis 48, in this embodiment.

In the illustrated embodiment, the capacitive sensing structure 37 is mirror symmetric with respect to both the y-axis 47 and the x-axis 48. Such symmetry achieves significant improvements in offset performance under package and/or internal/external stress relative to an asymmetric design.

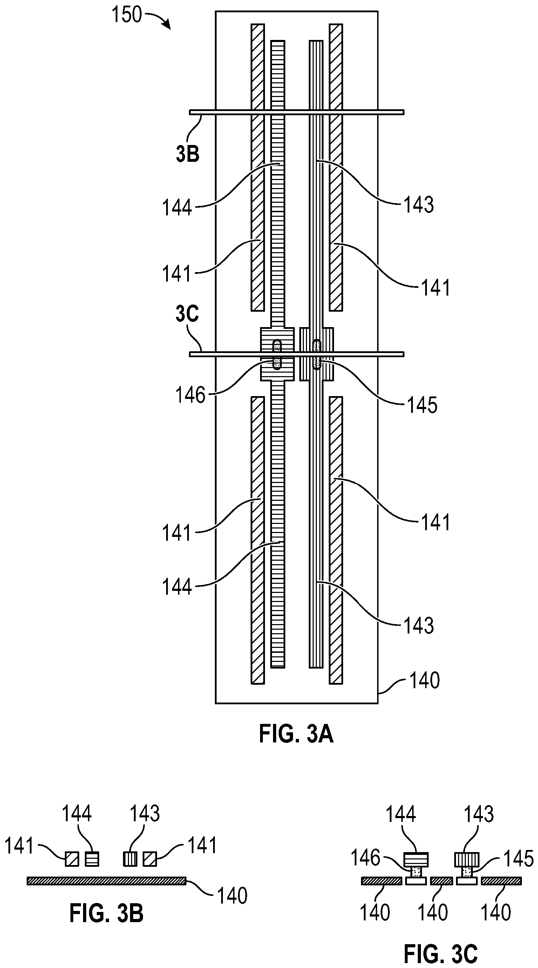

Figure 3A is a plan view of a capacitive sensing structure 150 according to another embodiment. Figure 3B is a first cross-section of the capacitive sensing structure 150 of Figure 3A taken along the line 3B. Figure 3C is a second cross-section of the capacitive sensing structure 150 of Figure 3A taken along the line 3C.

The capacitive sensing structure 150 is formed over a substrate 140, and includes moveable fingers 141, first fixed fingers 143, second fixed fingers 144, first fixed finger center anchor 145, and second fixed finger center anchor 146. The capacitive sensing structure 150 is an example of a fully symmetrical capacitive sensing structure that can be included in a MEMS sensor.

The moveable fingers 141 are attached to a proof mass, which is not shown in Figures 3A and 3B. The proof mass and moveable fingers 141 move relative to the substrate 140 and the fixed fingers 143/144, which are anchored to the substate 140.

The layout of the capacitive sensing structure 150 is fully symmetric in both x and y directions.

In the illustrated embodiment, the first fixed fingers 143 are anchored to the substrate 140 by the first fixed finger center anchor 145, which is placed at a center of the first fixed fingers 143. Additionally, the second fixed fingers 144 are anchored to the substate 140 by the second fixed finger center anchor 146, which is placed at a center of the second fixed fingers 144. The first fixed finger center anchor 145 and the second fixed finger center anchor 146 are aligned to provide co-alignment that reduces sensor offset.

Although Figures 3A-3C depict an embodiment in which the fixed fingers are anchored at the centers, the teachings herein are applicable to fixed fingers anchored in other ways.

In the illustrated embodiment, the first fixed finger center anchor 145 and the second fixed finger center anchor 146 are electrically conductive anchors, which are used both to anchor fixed fingers as well as to provide corresponding electrical connections to metal or polysilicon conductors formed on the substrate 140.

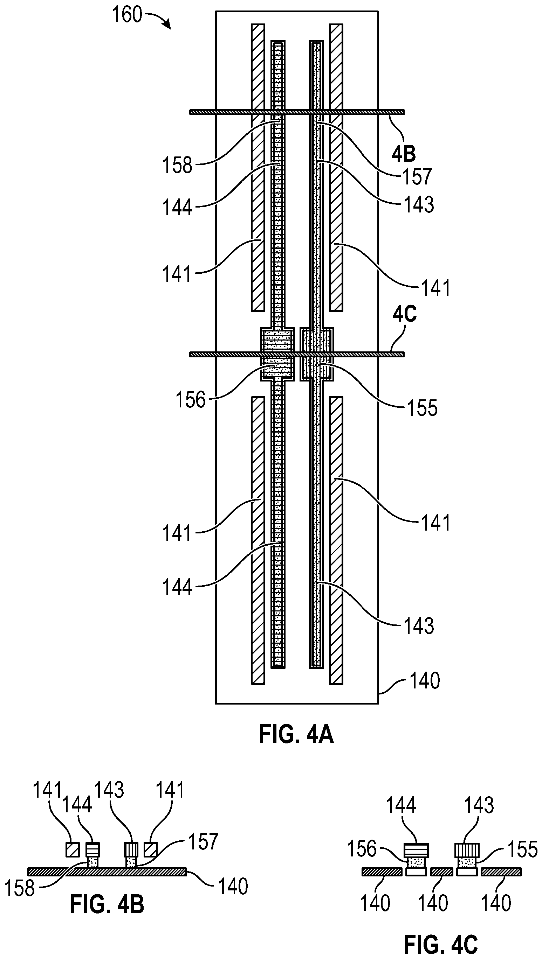

Figure 4A is a plan view of a capacitive sensing structure 160 according to another embodiment. Figure 4B is a first cross-section of the capacitive sensing structure 160 of Figure 4A taken along the line 4B. Figure 4C is a second cross-section of the capacitive sensing structure 160 of Figure 4A taken along the line 4C.

The capacitive sensing structure 160 is formed over a substrate 140, and includes moveable fingers 141, first fixed fingers 143, second fixed fingers 144, first fixed finger full anchor 155, and second fixed finger full anchor 156. The capacitive sensing structure 160 is another example of a fully symmetrical capacitive sensing structure that can be included in a MEMS sensor.

The capacitive sensing structure 160 of Figures 4A-4C is similar to the capacitive sensing structure 150 of Figures 3A-3C, except that the first fixed finger full anchor 155 and the second fixed finger full anchor 156 are whole finger anchors. Thus, rather than only anchoring the fixed fingers at the center as in Figures 3A-3C, whole finger anchors are used in Figures 4A-4C.

As shown in Figure 4B, a portion of the whole finger anchors include oxide anchors 157/158, which are electrically non-conductive. Furthermore, as shown in Figure 4C, electrical anchors 155/156 are also used to provide corresponding electrical connections to metal or polysilicon conductors formed on the substrate 140.

Thus, the capacitive sensing structure 160 of Figures 4A-4C uses a combination of oxide anchors and electrically conductive anchors. The oxide anchors provide a mechanical connection and can be connected to any desired structure. The electrically conductive anchors provide an electrical connection as well as a mechanical connection.

The oxide anchors herein can be formed using any suitable oxide or other dielectric layer. In one example, the oxide anchors are formed of a sacrificial oxide that is also used beneath the proof mass. Such a sacrificial oxide is removed beneath the proof mass to form a cavity and left beneath the fingers to form oxide finger anchors. In another example, an oxide is pre-etched and the fingers are bonded on top of the pre-etched oxide.

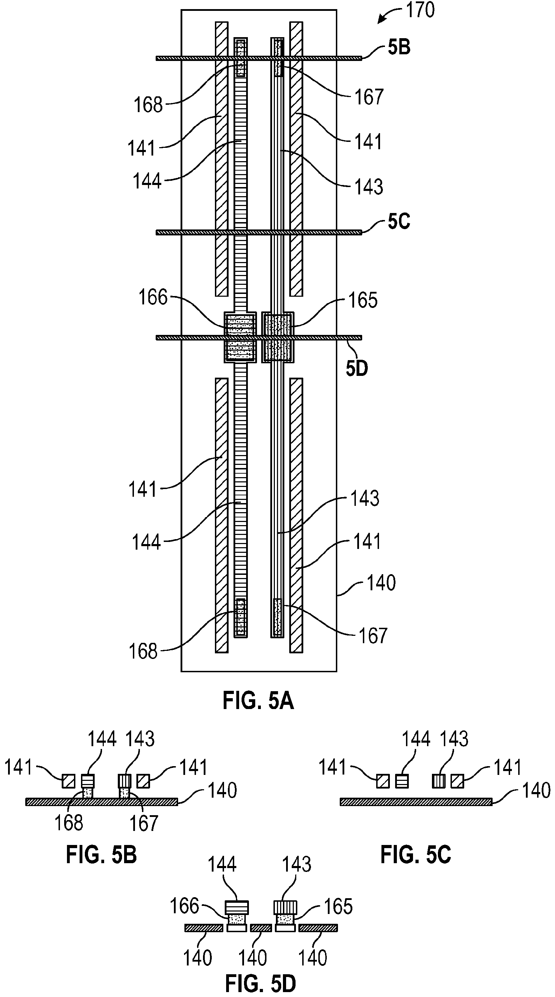

Figure 5A is a plan view of a capacitive sensing structure 170 according to another embodiment. Figure 5B is a first cross-section of the capacitive sensing structure 170 of Figure 5A taken along the line 5B. Figure 5C is a second cross-section of the capacitive sensing structure 170 of Figure 5A taken along the line 5C. Figure 5D is a third cross-section of the capacitive sensing structure 170 of Figure 5A taken along the line 5D.

The capacitive sensing structure 170 is formed over a substrate 140, and includes moveable fingers 141, first fixed fingers 143, second fixed fingers 144, first fixed finger center anchor 165, first fixed finger end anchors 167, second fixed finger center anchor 166, and second fixed finger end anchors 168. The capacitive sensing structure 170 is another example of a fully symmetrical capacitive sensing structure that can be included in a MEMS sensor.

The capacitive sensing structure 170 of Figures 5A-5D is similar to the capacitive sensing structure 150 of Figures 3A-3C, except that the capacitive sensing structure 170 of Figures 5A-5D anchors the fixed fingers to the substrate 140 at both the centers and the end points of the fixed fingers.

As shown in Figure 5B, the first fixed finger end anchors 167 and the second fixed finger end anchors 168 are oxide anchors. Furthermore, as shown in Figure 5D, the first fixed finger center anchor 165 and the second fixed finger center anchor 166 are conductive anchors that also provide an electrical connection to corresponding conductors on the substrate 140.

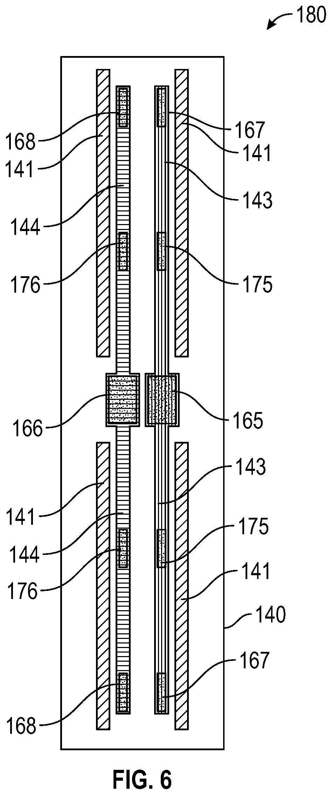

Figure 6 is a plan view of a capacitive sensing structure 180 according to another embodiment.

The capacitive sensing structure 180 is formed over a substrate 140, and includes moveable fingers 141, first fixed fingers 143, second fixed fingers 144, first fixed finger center anchor 165, first fixed finger end anchors 167, first fixed finger midpoint anchors 175, second fixed finger center anchor 166, second fixed finger end anchors 168, and second fixed finger midpoint anchors 176. The capacitive sensing structure 180 is another example of a fully symmetrical capacitive sensing structure that can be included in a MEMS sensor.

The capacitive sensing structure 180 of Figure 6 is similar to the capacitive sensing structure 170 of Figures 5A-5D, except that the capacitive sensing structure 180 of Figure 6 further anchors the fixed fingers to the substrate 140 at the midpoints.

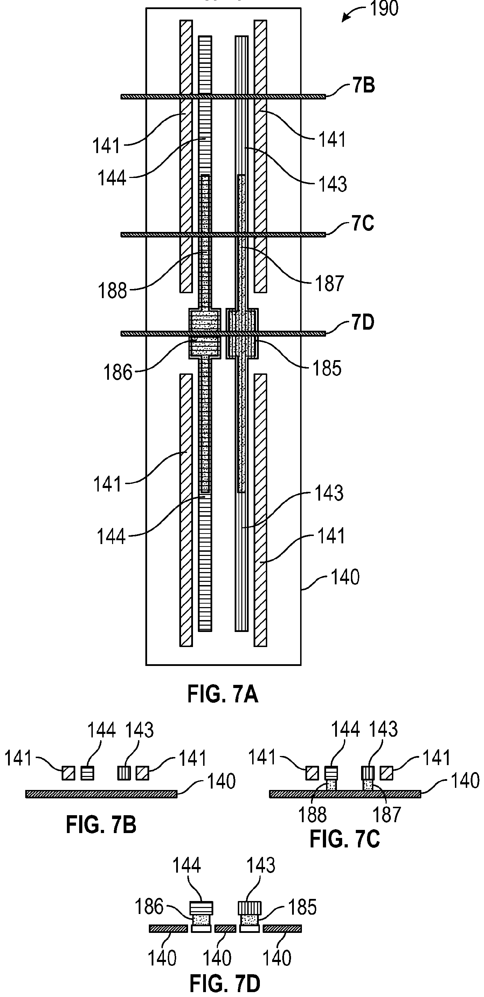

Figure 7A is a plan view of a capacitive sensing structure 190 according to another embodiment. Figure 7B is a first cross-section of the capacitive sensing structure 190 of Figure 7A taken along the line 7B. Figure 7C is a second cross-section of the capacitive sensing structure 190 of Figure 7A taken along the line 7C. Figure 7D is a third cross-section of the capacitive sensing structure 190 of Figure 7A taken along the line 7D.

The capacitive sensing structure 190 is formed over a substrate 140, and includes moveable fingers 141, first fixed fingers 143, second fixed fingers 144, first fixed finger half anchor 185, and second fixed finger half anchor 186. The capacitive sensing structure 190 is another example of a fully symmetrical capacitive sensing structure that can be included in a MEMS sensor.

The capacitive sensing structure 190 of Figures 7A-7D is similar to the capacitive sensing structure 150 of Figures 3A-3C, except that the fixed finger half anchor 185 and the second fixed finger half anchor 186 are half finger anchors. Thus, rather than only anchoring the fixed fingers at the center as in Figures 3A and 3B, half finger anchors are used in Figures 7A-7D.

As shown in Figure 7C, a portion of the half finger anchors include oxide anchors 187/188, which are electrically non-conductive. Furthermore, as shown in Figure 7D, electrical anchors 185/186 are also used to provide corresponding electrical connections to metal or polysilicon conductors formed on the substrate 140.

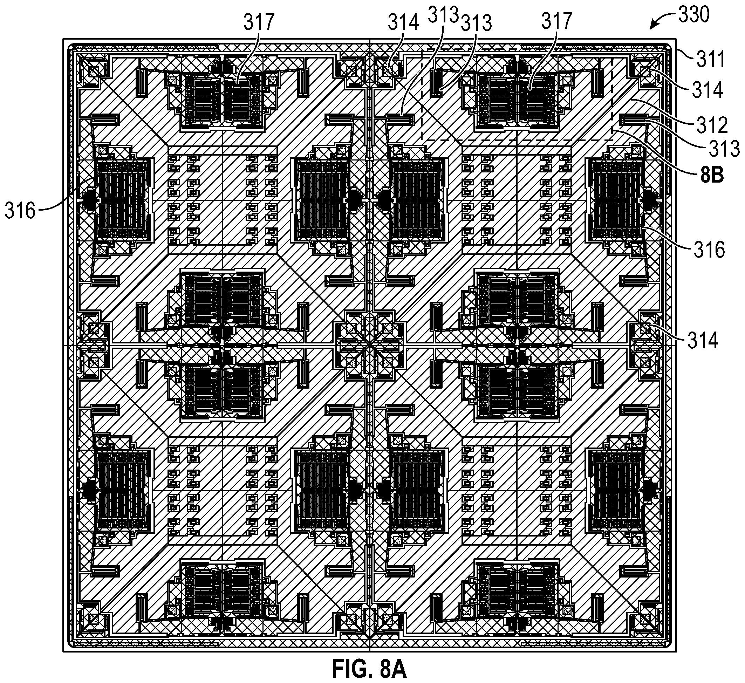

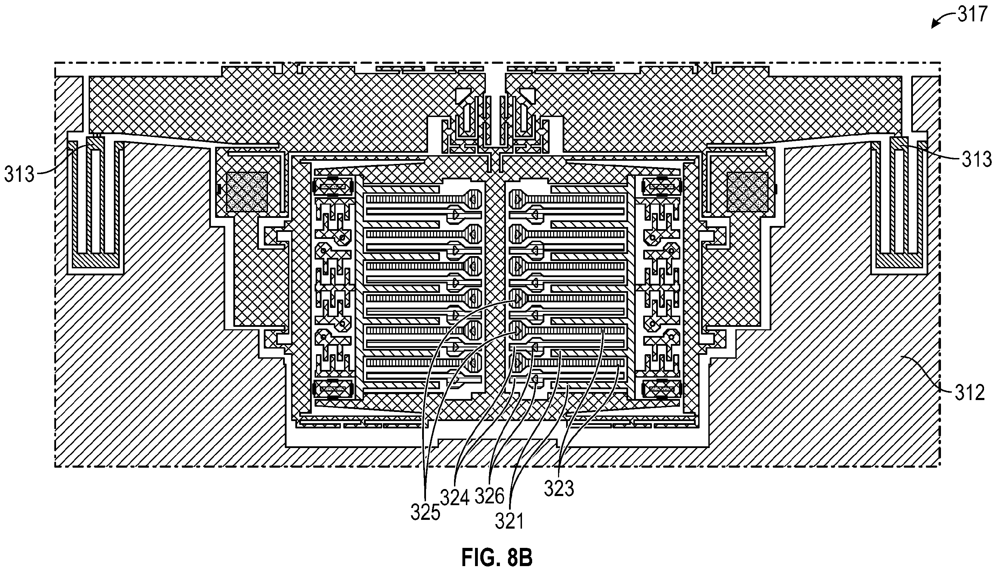

Figure 8A is a plan view of one example of a MEMS gyroscope 330. The gyroscope 330 includes a substrate 311, a proof mass 312 (also referred to as a resonator mass), springs 313, anchors 314, drive structures 316, and capacitive sensing structures 317. Figure 8B is a plan view of one of the capacitive sensing structures 317 of the MEMS gyroscope 330 of Figure 8A.

With reference to Figures 8A to 8B, the MEMS gyroscope 330 includes the proof mass 312 that is suspended by the springs 313 over the substrate 311. The proof mass 312 is driven in a first direction by the drive structures 316, and the capacitive sensing structures 317 measure a deflection of the proof mass 312 in a second direction arising from the Coriolis effect.

As shown in Figure 8B, the capacitive sensing structure 317 includes moveable fingers 321 that move with the proof mass 312. The capacitive sensing structure 317 also includes a first set of fixed fingers 323 that are anchored to the substrate 311 by a first set of finger anchors 325, and a second set of fixed fingers 324 that are anchored to the substrate 311 by a second set of finger anchors 326. The movable fingers 321 and fixed fingers 323/324 are interdigitated to form comb finger sets for sensing capacitance.

With continuing reference to Figures 8A and 8B, the layout of each of the capacitive sensing structures 317 has several asymmetries.

For example, as shown in Figure 8B the fixed fingers 323 and the second fixed fingers 324 are not fully symmetric to one another with respect to the moveable fingers 321 and are anchored on only one end. Furthermore, the first set of finger anchors 325 are not aligned with the second set of finger anchors 326.

Such asymmetries give rise to changes in offset and/or quadrature errors. For example, when the finger anchors rotate due to stress, the sensing gap between the moveable fingers 321 and the fixed fingers 323/324 changes and leads to undesirable sensor offset or quadrature error terms.

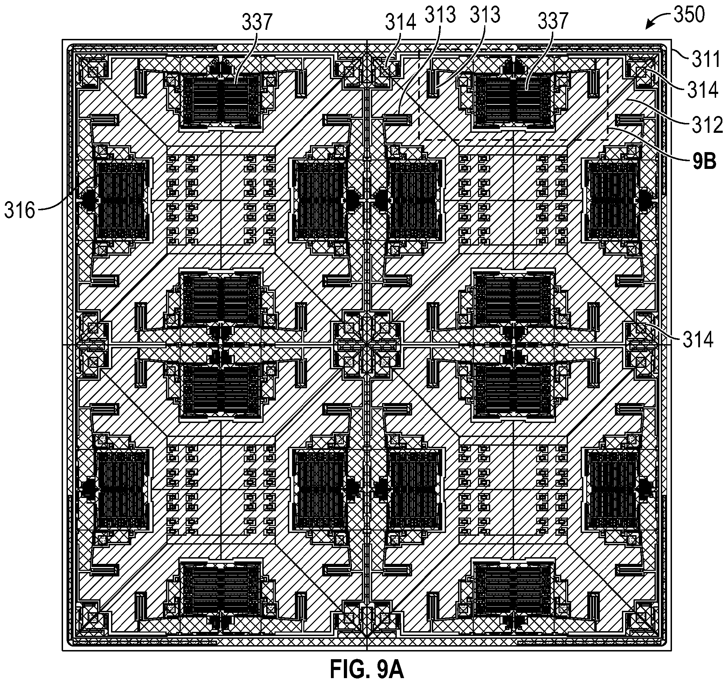

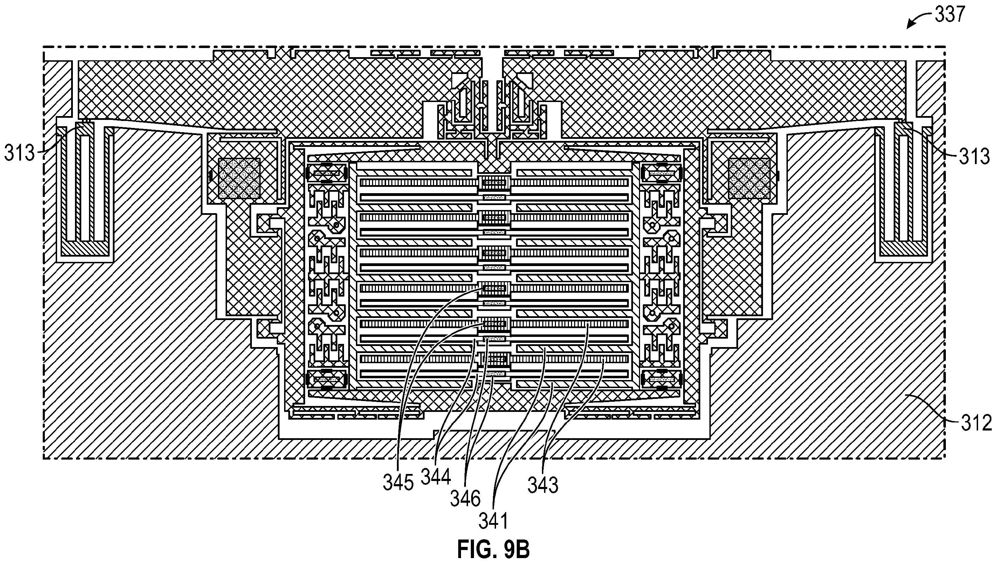

Figure 9A is a plan view of a MEMS gyroscope 350 with fully symmetrical sensing structures according to one embodiment. The MEMS gyroscope 350 includes a substrate 311, a proof mass 312, springs 313, anchors 314, drive structures 316, and capacitive sensing structures 337. Figure 9B is a plan view of one of the capacitive sensing structures 337 of the MEMS gyroscope 350 of Figure 9A.

As shown in Figure 9B, the capacitive sensing structure 337 includes moveable fingers 341 that move with the proof mass 312. The capacitive sensing structure 337 also includes a first set of fixed fingers 343 that are anchored to the substrate 311 by a first set of finger anchors 345, and a second set of fixed fingers 344 that are anchored to the substrate 311 by a second set of finger anchors 346. The movable fingers 341 and fixed fingers 343/344 are interdigitated to form comb finger sets for sensing capacitance.

With continuing reference to Figures 9A and 9B, the layout of each capacitive sensing structure is fully symmetric.

For example, as shown in Figure 9B the moveable fingers 341 of the capacitive sensing structure 337 extend symmetrically from opposite sides of the proof mass 312 and are fully symmetric with respect to the first set of fixed fingers 343 and the second set of fixed fingers 344.

Furthermore, the fixed fingers 343/344 shown in Figure 9B are symmetrically anchored. In contrast, the fixed fingers 323/324 shown in Figure 8B are anchored on only one end of each finger.

Moreover, the first set of finger anchors 345 are aligned with the second set of finger anchors 346. Such anchor co-alignment reduces sensor offset and/or quadrature errors generated by a location difference of the fixed anchors.

### Conclusion

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

While certain embodiments have been described, these embodiments have been presented by way of example only, and are not intended to limit the scope of the disclosure. Indeed, the novel apparatus, methods, and systems described herein may be embodied in a variety of other forms; furthermore, various omissions, substitutions and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible

There follows a list of numbered features defining particular embodiments of the invention. Where a numbered feature refers to one or more earlier numbered features then they should be considered together in combination.
1. A microelectromechanical systems (MEMS) sensor comprising:
   a proof mass configured to move in a first direction, the proof mass including a plurality of moveable fingers that move with the proof mass; and
   a plurality of fixed fingers that are fixed with respect to the plurality of moveable fingers,
   wherein a layout of the plurality of fixed fingers is fully symmetric in at least the first direction.
2. The MEMS sensor of feature 1, wherein each of the plurality of fixed fingers is anchored using at least one electrically conductive anchor.
3. The MEMS sensor of features 1 or 2, wherein each of the plurality of fixed fingers is anchored using at least one dielectric anchor.
4. The MEMS sensor of any of features 1 to 3, wherein each of the plurality of fixed fingers is anchored using at least one dielectric anchor and at least one electrically conductive anchor.
5. The MEMS sensor of any of features 1 to 4, further comprising a substrate, wherein the plurality of fixed fingers is symmetrically anchored to the substrate.
6. The MEMS sensor of feature 3, wherein each of the plurality of fixed fingers includes a center that is anchored to the substrate.
7. The MEMS sensor of features 3 or 6, wherein a first end and a second end of each of the plurality of fixed fingers is anchored to the substrate.
8. The MEMS sensor of any of features 3 to 7, wherein each of the plurality of fixed fingers is anchored to the substrate at three or more points.
9. The MEMS sensor of any of features 1 to 8, wherein the layout of the plurality of fixed fingers is fully symmetric in the first direction and a second direction.
10. The MEMS sensor of feature 7, wherein a layout of the plurality of moveable fingers is also fully symmetric in the first direction and the second direction.
11. The MEMS sensor of features 7 or 10, wherein the plurality of fixed fingers and the plurality of moveable fingers form a capacitive sensing structure.
12. The MEMS sensor of feature 9, wherein the capacitive sensing structure detects a Coriolis effect in the second direction arising from movement of the proof mass in the first direction.
13. The MEMS sensor of features 9 or 12, wherein the capacitive sensing structure detects a deflection of the proof mass to generate a sensor output with amplitude proportional to acceleration.
14. The MEMS sensor of any of features 1 to 13, implemented as a gyroscope.
15. The MEMS sensor of any of features 1 to 14, implemented as an accelerometer.
16. A method of microelectromechanical systems (MEMS) sensing, the method comprising:
   moving a proof mass in a first direction, the proof mass including a plurality of moveable fingers that move with the proof mass; and
   sensing a movement of the proof mass using the plurality of moveable fingers and a plurality of fixed fingers that are fixed with respect to the plurality of moveable fingers,
   wherein a layout of the plurality of fixed fingers is fully symmetric in at least the first direction.
17. The method of feature 12, further comprising a substrate, wherein the plurality of fixed fingers is symmetrically anchored to the substrate.
18. The method of feature 12 or 17, wherein the layout of the plurality of fixed fingers is fully symmetric in the first direction and a second direction.
19. The method of feature 1, wherein a layout of the plurality of moveable fingers is also fully symmetric in the first direction and the second direction.
20. The method of any of features 12 to 19, wherein each of the plurality of fixed fingers is anchored using at least one dielectric anchor and at least one electrically conductive anchor.

## Claims

1. A microelectromechanical systems (MEMS) sensor comprising:
a proof mass configured to move in a first direction, the proof mass including a plurality of moveable fingers that move with the proof mass; and
a plurality of fixed fingers that are fixed with respect to the plurality of moveable fingers,
wherein a layout of the plurality of fixed fingers is fully symmetric in at least the first direction.

2. The MEMS sensor of Claim 1, wherein each of the plurality of fixed fingers is anchored using one or more of:
a) at least one electrically conductive anchor;
b) at least one dielectric anchor; and/or
c) at least one dielectric anchor and at least one electrically conductive anchor.

3. The MEMS sensor of any of Claims 1 or 2, further comprising a substrate, wherein the plurality of fixed fingers is symmetrically anchored to the substrate.

4. The MEMS sensor of Claim 3, wherein each of the plurality of fixed fingers includes a center that is anchored to the substrate.

5. The MEMS sensor of Claims 3 or 4, wherein a first end and a second end of each of the plurality of fixed fingers is anchored to the substrate.

6. The MEMS sensor of any of Claims 3 to 5, wherein each of the plurality of fixed fingers is anchored to the substrate at three or more points.

7. The MEMS sensor of any of Claims 1 to 6, wherein the layout of the plurality of fixed fingers is fully symmetric in the first direction and a second direction.

8. The MEMS sensor of Claim 7, wherein a layout of the plurality of moveable fingers is also fully symmetric in the first direction and the second direction.

9. The MEMS sensor of Claims 7 or 8, wherein the plurality of fixed fingers and the plurality of moveable fingers form a capacitive sensing structure.

10. The MEMS sensor of Claim 9, wherein the capacitive sensing structure detects one or more of:
a) a Coriolis effect in the second direction arising from movement of the proof mass in the first direction; and/or
b) a deflection of the proof mass to generate a sensor output with amplitude proportional to acceleration.

11. The MEMS sensor of any of Claims 1 to 10, implemented as one or more of: a gyroscope; and/or an accelerometer.

12. A method of microelectromechanical systems (MEMS) sensing, the method comprising:
moving a proof mass in a first direction, the proof mass including a plurality of moveable fingers that move with the proof mass; and
sensing a movement of the proof mass using the plurality of moveable fingers and a plurality of fixed fingers that are fixed with respect to the plurality of moveable fingers,
wherein a layout of the plurality of fixed fingers is fully symmetric in at least the first direction.

13. The method of Claim 12, further comprising a substrate, wherein the plurality of fixed fingers is symmetrically anchored to the substrate.

14. The method of Claim 12 or 13, wherein the layout of the plurality of fixed fingers is fully symmetric in the first direction and a second direction; wherein optionally a layout of the plurality of moveable fingers is also fully symmetric in the first direction and the second direction.

15. The method of any of Claims 12 to 14, wherein each of the plurality of fixed fingers is anchored using at least one dielectric anchor and at least one electrically conductive anchor.
